# FASCICULE DE BREVET EUROPEEN

(11) **EP 3 185 279 B1**
(45) Date de publication et mention de la délivrance du brevet: **02.06.2021**
(21) Numéro de dépôt: 16204644.5
(22) Date de dépôt: 16.12.2016
(51) Int. Cl.: H01L 21/20, H01L 21/3105, H01L 21/321, H01L 21/3213, H01L 21/311

(54) **PROCEDE DE COLLAGE DIRECT ENTRE DEUX STRUCTURES**
DIREKTES VERKLEBEVERFAHREN ZWISCHEN ZWEI STRUKTUREN
DIRECT BONDING METHOD BETWEEN TWO STRUCTURES

(30) Priorité: 22.12.2015 FR 1563134
(43) Date de publication de la demande: 28.06.2017
(73) Titulaire: Commissariat à l'Energie Atomique et aux Energies Alternatives, 75015 Paris (FR)
(72) Inventeur: Moriceau, Hubert, 38120 Saint-Egrève (FR); Fournel, Frank, 38190 Villard-Bonnot (FR); Morales, Christophe, 38220 Saint-Pierre-de-Mésage (FR)
(74) Mandataire: Cabinet Beaumont

(56) Documents cités:
- EP-A1- 1 901 345
- FR-A1- 2 872 625
- US-A1- 2007 020 947
- U. GÖSELE ET AL: "SEMICONDUCTOR WAFER BONDING", ANNUAL REVIEW OF MATERIALS SCIENCE, vol. 28, no. 1, 1 août 1998 (1998-08-01), pages 215-241, XP055032047, ISSN: 0084-6600, DOI: 10.1146/annurev.matsci.28.1.215

## Description

### Domaine technique

La présente invention a trait à un procédé de collage d'une première structure et d'une seconde structure. Plus précisément, l'invention concerne un procédé de collage par adhésion directe de surfaces. Par « adhésion directe », on entend un collage spontané issu de la mise en contact direct de deux surfaces, c'est-à-dire en l'absence d'un élément additionnel tel qu'une colle, une cire ou une brasure. L'adhésion provient principalement des forces de van der Waals issues de l'interaction électronique entre les atomes ou les molécules de deux surfaces, des liaisons hydrogène du fait des préparations des surfaces ou des liaisons covalentes établies entre les deux surfaces. On parle également de collage par adhésion moléculaire.

Classiquement, une forte tenue de collage (c'est-à-dire avec une énergie de séparation supérieure à 3 J.m⁻², mesure faite par insertion d'une lame à l'interface de collage) est recherchée tout en n'impliquant aucun traitement thermique de l'interface de collage à une température élevée, typiquement supérieure à 100°C.

### Etat de la technique antérieure

Il est connu de l'état de la technique d'utiliser une activation des surfaces par des traitements à base de plasma, ou encore par des techniques de polissage. De telles activations de surface améliorent la tenue de collage mais ne permettent pas d'obtenir une énergie de collage supérieure 3 J.m⁻² sans appliquer un traitement thermique à une température supérieure à 100°C.

Il est également connu de l'état de la technique, notamment du document T. Suni et al., « Effects of plasma activation on hydrophilic bonding of Si and SiO2 », Journal of The Electrochemical Society, 149 (6) G348-G351 (2008), d'activer des surfaces d'oxydes de silicium par un plasma de type RF sous une atmosphère d'oxygène. Une telle activation de surface ne permet pas d'obtenir une énergie de collage supérieure 3 J.m⁻², tout en appliquant un traitement thermique à une température supérieure à 100°C.

Par ailleurs, il est connu de l'état de la technique, notamment du document H. Takagi et al., « Room-temperature Bonding of Oxide Wafers by Ar-beam Surface Activation », ECS Transactions, 16(8), pp. 531-537 (2008), d'activer des surfaces de deux plaques de silicium par faisceau d'ions argon. Les séparations des collages des plaques de silicium ainsi traitées se font par rupture de silicium dans au moins une des plaques, ce qui signifie une forte énergie de collage, estimée supérieure à 4 J.m⁻². En revanche, comme le montre ce même article, cette activation de surface est inopérante lorsque les deux plaques de silicium sont recouvertes d'un film d'oxyde de silicium avant l'activation de surface ou lorsque les plaques sont principalement en oxyde de silicium. L'énergie de collage obtenue n'est que de l'ordre de une à quelques centaines de mJ.m⁻² à température ambiante, et reste inférieure à 2 J.m⁻² malgré un traitement thermique à 200°C.

EP 1 901 345 A1, US 2007/020947 A1 et FR 2 872 625 A1 divulguent des procédés de collage connus de l'état de la technique.

### Exposé de l'invention

Ainsi, la présente invention vise à remédier en tout ou partie aux inconvénients précités, et concerne à cet effet un procédé de collage d'une première structure et d'une seconde structure, comportant les étapes :
a) fournir la première structure et la seconde structure, la première structure comportant une surface sur laquelle est formée une couche de silicium ;
b) bombarder la couche de silicium par un faisceau d'espèces configuré pour atteindre la surface de la première structure, et pour conserver une partie de la couche de silicium avec une rugosité de surface inférieure à 1 nm RMS à l'issue du bombardement ;
c) coller la première structure et la seconde structure par une adhésion directe entre la partie de la couche de silicium conservée lors de l'étape b) et la seconde structure, les étapes b) et c) étant exécutées au sein d'une même enceinte soumise à un vide inférieur à 10⁻² mbar.

Ainsi, un tel procédé selon l'invention permet d'envisager l'obtention d'une énergie de collage supérieure à 3 J.m⁻², tout en s'affranchissant d'un traitement thermique de l'interface de collage à une température supérieure à 100°C.

En effet, une telle étape b) permet à la fois de :
- abraser la couche de silicium formée lors de l'étape a) lorsque celle-ci présente une épaisseur supérieure à la profondeur de pénétration des espèces (telles que des ions), et atteindre l'épaisseur souhaitée pour la partie de la couche de silicium conservée,
- renforcer l'interface, en termes d'adhérence, entre la couche de silicium et la surface de la première structure grâce à leur mixage par les espèces bombardées lorsque l'épaisseur de la couche de silicium formée lors de l'étape a) est -ou devient après abrasion- inférieure ou égale à la profondeur de pénétration des espèces (telles que des ions), et
- activer la surface de la couche de silicium au sens de préparer la surface en vue de son collage lors de l'étape c). Une telle préparation vise notamment à générer des liaisons pendantes de silicium en surface, ce qui est rendu possible par un vide poussé dans l'enceinte, préférentiellement inférieur à 10⁻⁴ mbar, plus préférentiellement inférieur à 10⁻⁵ mbar, encore plus préférentiellement inférieur à 10⁻⁶ mbar.

Pour ce faire, le faisceau d'espèces est configuré pour atteindre la surface de la première structure sans abraser entièrement la couche de silicium. Ainsi, la surface de la partie de la couche de silicium conservée est activée (au sens de préparée) et son mixage avec le matériau de la surface de la première structure (par exemple un oxyde de silicium) est obtenu grâce aux espèces bombardées, ce qui permet ainsi d'augmenter l'adhérence de la couche de silicium déposée sur un oxyde de silicium, à titre d'exemple non limitatif. Par « configuré pour », on entend que les paramètres du bombardement (principalement l'énergie et le courant) et les paramètres de traitement (principalement la durée d'opération, la température, la pression) sont choisis selon la nature des espèces, avantageusement des ions à accélérer (ces ions pouvant être plus ou moins neutralisés après leur accélération), pour conserver une partie de la couche de silicium avec une rugosité de surface inférieure à 1 nm RMS, et pour atteindre la surface de la première structure. En d'autres termes, à l'issue du bombardement de l'étape b), la partie de la couche de silicium conservée comporte une surface libre présentant une rugosité inférieure à 1 nm RMS, préférentiellement inférieure à 0,5 nm RMS, plus préférentiellement inférieure à 0,3 nm RMS, de manière à rester compatible avec le collage subséquent de l'étape c).

La quantification de la rugosité de surface s'entend relativement à une rugosité moyenne quadratique (Sq) d'une surface de référence, et est définie dans la norme ISO 25178 (anciennement appelée Rq dans la norme ISO 4287, et également appelée RMS pour « *Root mean square* » en langue anglaise). Sq est mesurée par une technique décrite dans la norme ISO 25178, par exemple via un balayage AFM *(« Atomic Force Microscope* » en langue anglaise) sur une surface de référence de 1*1 µm².

En outre, pour ce faire, les étapes b) et c) sont effectuées sous un vide poussé, et sans rupture de vide. Par exemple, le vide poussé peut être un vide secondaire inférieur à 10⁻² mbar, ou encore un ultra-vide inférieur à 10⁻⁷ mbar.

Avantageusement, l'étape b) est exécutée de sorte que la partie de la couche de silicium conservée présente une épaisseur comprise entre 0,2 nm et 5 nm, préférentiellement comprise entre 1 nm et 5 nm, plus préférentiellement comprise entre 3 nm et 5 nm.

Ainsi, de telles épaisseurs permettent au faisceau d'atteindre la surface de la première structure et d'autoriser par là-même le mixage de la partie de la couche de silicium et de la surface de la première structure par les espèces bombardées, et ce sans nécessiter une énergie trop élevée (typiquement inférieure à quelques keV).

En outre, lorsque la couche de silicium formée lors de l'étape a) présente une épaisseur très supérieure à 5 nm (par exemple 10 nm ou 15 nm), le procédé comporte préférentiellement une étape préalable consistant à graver ladite couche de silicium, en voie sèche (bombardement, voie gazeuse) ou en voie humide, de sorte que la couche de silicium présente une épaisseur de l'ordre de 5 nm avant l'étape b).

Selon une alternative, l'étape b) comporte les sous-étapes :
s1) provoquer par un bombardement le mixage de l'interface entre la couche de silicium et la surface de la première structure, la couche de silicium présentant une épaisseur inférieure ou égale à la profondeur de pénétration des espèces ;
s2) épaissir la couche de silicium par un dépôt ;
s3) activer la surface de la couche de silicium épaissie lors de s2) par un bombardement, au sens de préparer la surface en vue de l'étape c) de collage. Une telle préparation vise notamment à générer des liaisons pendantes de silicium en surface, ce qui est rendu possible par un vide poussé dans l'enceinte, préférentiellement inférieur à 10⁻⁴ mbar, plus préférentiellement inférieur à 10⁻⁵ mbar, encore plus préférentiellement inférieur à 10⁻⁶ mbar.

Suivant cette alternative, la couche de silicium peut être épaissie ultérieurement par dépôt, pour atteindre des épaisseurs supérieures à 5 nm, par exemple 20 nm ou 50 nm. L'activation de surface peut alors être provoquée par un bombardement ionique complémentaire.

Avantageusement, les espèces du faisceau comportent au moins un élément sélectionné dans le groupe comportant Ar, Ne, N, H, O, He.

Selon une alternative, les espèces du faisceau comportent des atomes de silicium.

Selon un mode de réalisation, la première structure fournie lors de l'étape a) comporte successivement :
- un substrat d'un premier matériau ;
- une couche d'un deuxième matériau comportant la surface sur laquelle est formée la couche de silicium.

Selon un mode de réalisation, la seconde structure fournie lors de l'étape a) comporte successivement :
- un substrat d'un premier matériau ;
- une couche d'un deuxième matériau sur laquelle s'opère l'adhésion directe lors de l'étape c).

Selon une forme d'exécution, le deuxième matériau de la couche est sélectionné dans le groupe comportant un oxyde de silicium, un nitrure de silicium, un nitrure d'aluminium, un oxyde d'aluminium, un oxynitrure de silicium, un carbure de silicium, un diamant, un matériau de type III-V, un matériau de type II-VI, un matériau de type IV.

Par « matériau de type A-B », on entend un alliage binaire entre des éléments situés respectivement dans les colonnes A et B du tableau périodique des éléments.

Selon une forme d'exécution, le premier matériau du substrat est sélectionné dans le groupe comportant le silicium, un verre, un saphir, un matériau de type III-V, un diamant, un carbure de silicium, une alumine, un polymère, une céramique.

Avantageusement, les première et seconde structures forment un empilement lors de l'étape c), et l'étape c) est exécutée en exerçant une pression sur au moins une surface libre de l'empilement suivant la normale à la surface libre, la pression étant préférentiellement comprise entre 5 et 30 bar.

Avantageusement, le procédé comporte une étape consistant à appliquer un recuit thermique à la première structure avant l'étape b), le recuit thermique présentant une température T vérifiant T<T₂ où T₂ est la température au-delà de laquelle la première structure est susceptible de se dégrader.

La température T du recuit thermique vérifie avantageusement T>T₁ où T₁ est la température à partir de laquelle des gaz inclus au cours des dépôts ou sous-produits de réaction (par exemple hydrogène, eau, hydrocarbures) diffusent hors de la couche de silicium.

Selon une forme d'exécution, la couche de silicium est amorphe ou polycristalline.

Par « amorphe », on entend que la couche de silicium présente un taux de cristallinité massique inférieur à 20%.

Par « polycristalline », on entend que la couche de silicium présente un taux de cristallinité massique compris entre 20% et strictement inférieur à 100%.

Par « monocristalline », on entend que la couche de silicium présente un taux de cristallinité massique égal à 100%.

Selon une forme d'exécution, la première structure fournie lors de l'étape a) comporte un oxyde de silicium formé sur la couche de silicium, et le procédé comporte une étape consistant à retirer l'oxyde de silicium avant l'étape b).

Ainsi, la surface de la couche de silicium est rendue hydrophobe.

Selon une forme d'exécution, l'étape a) comporte une étape consistant à déposer la couche de silicium sur la surface de la première structure, de préférence à une température inférieure à 600°C, plus préférentiellement inférieure à 500°C.

Avantageusement, la seconde structure fournie lors de l'étape a) comporte une surface sur laquelle est formée une couche de silicium additionnelle; le procédé comporte une étape b1) consistant à bombarder la couche de silicium additionnelle par un faisceau d'espèces configuré pour atteindre la surface de la seconde structure, et pour conserver une partie de la couche de silicium additionnelle avec une rugosité de surface inférieure à 1 nm RMS à l'issue du bombardement, l'étape b1) étant exécutée au sein de la même enceinte soumise au vide inférieur à 10⁻² mbar ; et l'étape c) est exécutée de sorte que l'adhésion directe s'opère entre la partie de la couche de silicium conservée lors de l'étape b) et la partie de la couche de silicium additionnelle conservée lors de l'étape b1).

Ainsi, de manière analogue, une telle étape b1) permet à la fois de :
- abraser la couche de silicium additionnelle formée lors de l'étape a) lorsque celle-ci présente une épaisseur supérieure à la profondeur des espèces (telles que des ions), et atteindre l'épaisseur souhaitée pour la partie de la couche de silicium additionnelle conservée,
- renforcer l'interface, en termes d'adhérence, entre la couche de silicium additionnelle et la surface de la seconde structure grâce à leur mixage par les espèces bombardées lorsque l'épaisseur de la couche de silicium additionnelle formée lors de l'étape a) est -ou devient après abrasion- inférieure ou égale à la profondeur de pénétration des espèces (telles que des ions), et
- activer la surface de la couche de silicium additionnelle au sens de préparer la surface en vue de son collage lors de l'étape c). Une telle préparation vise notamment à générer des liaisons pendantes de silicium en surface, ce qui est rendu possible par un vide poussé dans l'enceinte, préférentiellement inférieur à 10⁻⁴ mbar, plus préférentiellement inférieur à 10⁻⁵ mbar, encore plus préférentiellement inférieur à 10⁻⁶ mbar.

En d'autres termes, à l'issue du bombardement de l'étape b1), la partie de la couche de silicium additionnelle conservée comporte une surface libre présentant une rugosité inférieure à 1 nm RMS, préférentiellement inférieure à 0,5 nm RMS, plus préférentiellement inférieure à 0,3 nm RMS, de manière à rester compatible avec le collage subséquent de l'étape c).

Selon une variante, la seconde structure fournie lors de l'étape a) comporte une surface sur laquelle s'opère l'adhésion directe lors de l'étape c), et le procédé comporte une étape consistant à bombarder la surface avant l'étape c) par un faisceau d'espèces configuré pour conserver une rugosité de surface inférieure à 1 nm RMS.

En d'autres termes, à l'issue du bombardement, la rugosité de la surface de la seconde structure est inférieure à 1 nm RMS, préférentiellement inférieure à 0,5 nm RMS, plus préférentiellement inférieure à 0,3 nm RMS.

Ainsi, la surface de la seconde structure est activée avant l'adhésion directe de l'étape c).

Par « rugosité de surface », on entend une rugosité moyenne quadratique définie dans la norme ISO 25178, et notée Sq.

Avantageusement, le procédé est dépourvu d'une étape de recuit thermique présentant une température supérieure à 100°C après l'étape c).

### Brève description des dessins

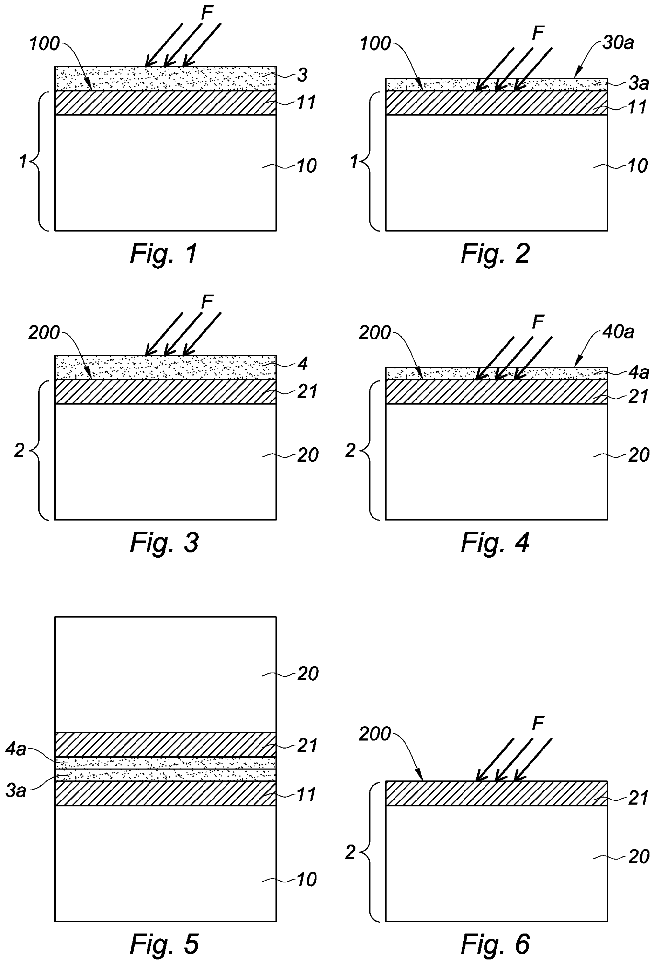

D'autres caractéristiques et avantages apparaîtront dans la description qui va suivre de différents modes de réalisation de l'invention, donnés à titre d'exemples non limitatifs, en référence aux dessins annexés dans lesquels les figures 1 à 6 sont des vues schématiques en coupe illustrant des étapes d'un procédé selon l'invention.

### Exposé détaillé des modes de réalisation

Pour les différents modes de réalisation, les mêmes références seront utilisées pour des éléments identiques ou assurant la même fonction, par souci de simplification de la description. Les caractéristiques techniques décrites ci-après pour différents modes de réalisation sont à considérer isolément ou selon toute combinaison techniquement possible.

Le procédé illustré aux figures 1 à 6 est un procédé de collage d'une première structure 1 et d'une seconde structure 2, comportant les étapes :
a) fournir la première structure 1 et la seconde structure 2, la première structure 1 comportant une surface 100 sur laquelle est formée une couche de silicium 3 ;
b) bombarder la couche de silicium 3 par un faisceau F d'espèces configuré pour atteindre la surface 100 de la première structure 1, et pour conserver une partie 3a de la couche de silicium 3 avec une rugosité de surface inférieure à 1 nm RMS à l'issue du bombardement;
c) coller la première structure 1 et la seconde structure 2 par une adhésion directe entre la partie 3a de la couche de silicium 3 conservée lors de l'étape b) et la seconde structure 2.

Les étapes b) et c) sont exécutées au sein d'une même enceinte soumise à un vide inférieur à 10⁻² mbar.

### Première structure

Comme illustré à la figure 1, préférentiellement, la première structure 1 fournie lors de l'étape a) comporte successivement :
- un substrat 10 d'un premier matériau ;
- une couche 11 d'un deuxième matériau comportant la surface 100 sur laquelle est formée la couche de silicium 3.

Le premier matériau du substrat 10 est avantageusement sélectionné dans le groupe comportant le silicium, un verre, un saphir, un matériau de type III-V, un diamant, un carbure de silicium, une alumine, un polymère, une céramique. Le premier matériau est unique ou composite.

Le deuxième matériau de la couche 11 est avantageusement sélectionné dans le groupe comportant un oxyde de silicium, un nitrure de silicium, un nitrure d'aluminium, un oxyde d'aluminium, un oxynitrure de silicium, un carbure de silicium, un diamant, un matériau de type III-V (par exemple GaAs ou InP), un matériau de type II-VI (par exemple CdTe, ZnO, CdSe), un matériau de type IV.

Lorsque le premier matériau du substrat 10 est le silicium et lorsque le deuxième matériau de la couche 11 est un oxyde de silicium, l'oxyde de silicium peut être formé sur le substrat de silicium soit par une oxydation thermique, soit par une technique de dépôt de film.

Le procédé comporte avantageusement une étape consistant à aplanir la couche 11 avant la formation de la couche de silicium 3, préférentiellement par un polissage mécano-chimique, de manière à obtenir une rugosité de surface suffisamment faible (de l'ordre de 2 Å RMS mesurée sur un scan AFM de 1*1 µm²) pour l'adhésion directe de l'étape c).

Le procédé comporte avantageusement une étape consistant à nettoyer la surface 100 de la première structure 1 avant la formation de la couche de silicium 3, de préférence par un nettoyage de type RCA.

L'étape a) comporte préférentiellement une étape consistant à déposer la couche de silicium 3 sur la surface 100 de la première structure 1, de préférence à une température inférieure à 600°C, plus préférentiellement inférieure à 500°C. La couche de silicium 3 déposée est amorphe ou polycristalline. A titre d'exemple, la couche de silicium 3 peut être déposée par un dépôt physique ou chimique en phase vapeur.

L'étape a) comporte avantageusement une étape consistant à nettoyer la surface de la couche de silicium 3 formée, de préférence par un nettoyage de type RCA. Un tel nettoyage de type RCA permet de retirer les particules ou les contaminations à la surface de la couche de silicium 3 formée, tout en conservant un film d'oxyde chimique fin (de l'ordre de 0,6 nm). La surface de la couche de silicium 3 nettoyée est alors hydrophile, avec des angles de mouillage de gouttes d'eau inférieurs à 2°.

Selon une alternative, l'étape a) comporte avantageusement une étape consistant à aplanir la couche de silicium 3 formée, préférentiellement par un polissage mécano-chimique, de manière à obtenir une rugosité de surface suffisamment faible (de l'ordre de 2 Å RMS mesurée sur un scan AFM de 1*1 µm²) pour l'adhésion directe de l'étape c).

La première structure 1 fournie lors de l'étape a) peut comporter un oxyde de silicium formé sur la couche de silicium 3. Le procédé comporte alors avantageusement une étape consistant à retirer l'oxyde de silicium avant l'étape b). Le retrait de l'oxyde de silicium est avantageusement exécuté par une gravure, de préférence avec une solution d'acide fluorhydrique. Cette gravure est avantageusement la dernière étape exécutée avant l'étape b) (« *HF last* » en langue anglaise) afin d'éviter la formation d'un oxyde à la surface de la couche de silicium 3.

Le procédé comporte avantageusement une étape consistant à appliquer un recuit thermique à la première structure 1 avant l'étape b), le recuit thermique présentant une température T vérifiant T<T₂ où T₂ est la température au-delà de laquelle la première structure 1 est susceptible de se dégrader, par exemple 525°C avec une couche de silicium 3 amorphe.

La température T du recuit thermique vérifie avantageusement T>T₁ où T₁ est la température à partir de laquelle des gaz inclus au cours des dépôts ou sous-produits de réaction (par exemple hydrogène, eau, hydrocarbures) diffusent hors de la couche de silicium. T₁ est par exemple comprise entre 100°C et 500°C.

### Seconde structure

Comme illustré à la figure 6, préférentiellement, la seconde structure 2 fournie lors de l'étape a) comporte successivement :
- un substrat 20 d'un premier matériau ;
- une couche 21 d'un deuxième matériau comportant une surface 200 sur laquelle s'opère l'adhésion directe lors de l'étape c).

Le premier matériau du substrat 20 est avantageusement sélectionné dans le groupe comportant le silicium, un verre, un saphir, un matériau de type III-V, un diamant, un carbure de silicium, une alumine, un polymère, une céramique. Le premier matériau est unique ou composite.

Le deuxième matériau de la couche 21 est avantageusement sélectionné dans le groupe comportant un oxyde de silicium, un nitrure de silicium, un nitrure d'aluminium, un oxyde d'aluminium, un oxynitrure de silicium, un carbure de silicium, un diamant, un matériau de type III-V (par exemple GaAs ou InP), un matériau de type II-VI (par exemple CdTe, ZnO, CdSe), un matériau de type IV.

Lorsque le premier matériau du substrat 20 est le silicium et lorsque le deuxième matériau de la couche 21 est un oxyde de silicium, l'oxyde de silicium peut être formé sur le substrat de silicium soit par une oxydation thermique, soit par une technique de dépôt de film.

Le procédé comporte avantageusement une étape consistant à aplanir la couche 21 de manière à obtenir une rugosité de surface suffisamment faible (de l'ordre de 2 Å RMS mesurée sur un scan AFM de 1*1 µm²) pour l'adhésion directe de l'étape c).

L'étape a) comporte avantageusement une étape consistant à nettoyer la surface 200 de la couche 21, de préférence par un nettoyage de type RCA, afin de retirer les particules ou les contaminations de la surface 200.

### Bombardement

L'étape b) est avantageusement exécutée de sorte que la partie 3a de la couche de silicium 3 conservée présente une épaisseur comprise entre 0,2 nm et 5 nm, préférentiellement comprise entre 1 nm et 5 nm, plus préférentiellement comprise entre 3 nm et 5 nm. L'étape b) est avantageusement exécutée de sorte que la partie 3a de la couche de silicium 3 conservée présente une épaisseur comprise 0,2 nm et 10 nm, plus préférentiellement comprise entre 1 nm et 5 nm, encore plus préférentiellement comprise entre 2 nm et 5 nm. Lorsque la couche de silicium 3 formée lors de l'étape a) présente une épaisseur très supérieure à 5 nm (par exemple 10 nm ou 15 nm), le procédé comporte préférentiellement une étape b0) consistant à graver ladite couche de silicium 3, en voie sèche ou en voie humide, de sorte que la couche de silicium 3 présente une épaisseur de l'ordre de 5 nm avant l'étape b). L'étape b0) est une étape préalable à l'étape b) ou peut avoir lieu pendant une phase initiale de l'étape b).

Le bombardement est avantageusement réalisé lors de l'étape b) à l'aide d'un faisceau d'ions. Ce bombardement est communément référencé comme une étape de gravure par faisceau d'ions (IBE pour « *Ion Beam Etching* » ou IBM pour « *Ion Beam Etching* » en langue anglaise). Les sources utilisées peuvent être :
- de type FAB (« *Fast Atom Beam* » en langue anglaise) pour un bombardement d'argon notamment,
- de type Kaufmann où les ions sont générés par collision avec des électrons confinés dans un champ magnétique.

Par « épaisseur », on entend la dimension suivant la normale au substrat 10. Les espèces du faisceau F comportent avantageusement au moins un élément sélectionné dans le groupe comportant Ar, Ne, N, H, O, He.

Plus précisément, les paramètres du bombardement (principalement l'énergie et le courant) et les paramètres de traitement (principalement la durée d'opération, la température, la pression) sont choisis pour :
- obtenir une vitesse d'abrasion telle que la partie 3a de la couche de silicium 3 conservée présente une épaisseur préférentiellement comprise entre 3 nm et 5 nm,
- obtenir une rugosité inférieure à 1 nm RMS (voire inférieure à 0,5 nm RMS, voire inférieure à 0,3 nm RMS) à la surface libre 30a de ladite partie 3a conservée à l'issue du bombardement.

A titre d'exemple, la vitesse d'abrasion de la couche de silicium 3 peut être comprise entre 9 nm/min et 12 nm/min.

Comme illustré à la figure 6, l'étape b) comporte avantageusement une étape consistant à bombarder la surface 200 de la couche 21 de la seconde structure 2 par un faisceau F d'espèces. Le faisceau F est configuré pour que la surface 200 conserve une rugosité inférieure à 1 nm RMS (voire inférieure à 0,5 nm RMS, voire inférieure à 0,3 nm RMS) à l'issue du bombardement. Il en résulte une abrasion de la couche 21 et une activation de la surface 200. A titre d'exemple, lorsque la couche 21 est un oxyde de silicium, la vitesse d'abrasion de la couche 21 peut être de l'ordre de 8,5 nm/min. Ce mode de réalisation est utilisé en l'absence de couche de silicium additionnelle 4 (mode de réalisation illustré à la figure 3, cf infra).

### Collage

Les première et seconde structures 1, 2 forment un empilement lors de l'étape c), et l'étape c) est avantageusement exécutée en exerçant une pression sur au moins une surface libre de l'empilement suivant la normale à la surface libre, la pression étant préférentiellement comprise entre 5 et 30 bar. La pression est avantageusement exercée sur les deux surfaces libres de l'empilement aux moyens de deux plaques.

Le vide auquel est soumise l'enceinte est avantageusement compris entre 10⁻¹⁴ et 10⁻² mbar, préférentiellement compris entre 10⁻⁸ et 10⁻⁴ mbar. Le vide auquel est soumise l'enceinte est préférentiellement inférieur à 10⁻⁴ mbar, plus préférentiellement inférieur à 10⁻⁵ mbar, encore plus préférentiellement inférieur à 10⁻⁶ mbar, ce qui permet de conserver des liaisons pendantes de silicium et d'améliorer la qualité de collage par la création de liaisons covalentes.

### Couche de silicium additionnelle

Selon un mode de réalisation illustré à la figure 3, la seconde structure 2 fournie lors de l'étape a) comporte une surface 200 sur laquelle est formée une couche de silicium additionnelle 4. Le procédé comporte avantageusement une étape b1) consistant à bombarder la couche de silicium additionnelle 4 par un faisceau F d'espèces configuré pour atteindre la surface 200 de la seconde structure 2, et pour conserver une partie 4a de la couche de silicium additionnelle 4 avec une rugosité de surface inférieure à 1 nm RMS à l'issue du bombardement (illustré à la figure 4). L'étape b1) est avantageusement exécutée au sein de la même enceinte soumise au vide inférieur à 10⁻² mbar. L'étape c) est exécutée de sorte que l'adhésion directe s'opère entre la partie 3a de la couche de silicium 3 conservée lors de l'étape b) et la partie 4a de la couche de silicium additionnelle 4 conservée lors de l'étape b1).

Les caractéristiques techniques décrites pour la couche de silicium 3 (et la partie 3a) s'appliquent également pour la couche de silicium additionnelle 4 (et la partie 4a). En particulier, le vide auquel est soumise l'enceinte est préférentiellement inférieur à 10⁻⁴ mbar, plus préférentiellement inférieur à 10⁻⁵ mbar, encore plus préférentiellement inférieur à 10⁻⁶ mbar, ce qui permet de conserver des liaisons pendantes de silicium et d'améliorer la qualité de collage par la création de liaisons covalentes.

Les caractéristiques décrites pour le bombardement de l'étape b) s'appliquent également pour le bombardement de l'étape b1).

En particulier, les paramètres du bombardement de l'étape b1) (principalement l'énergie et le courant) et les paramètres de traitement (principalement la durée d'opération, la température, la pression) sont choisis pour :
- obtenir une vitesse d'abrasion telle que la partie 4a de la couche de silicium additionnelle 4 conservée présente une épaisseur préférentiellement comprise entre 3 nm et 5 nm,
- obtenir une rugosité inférieure à 1 nm RMS (voire inférieure à 0,5 nm RMS, voire inférieure à 0,3 nm RMS) à la surface libre 40a de ladite partie 4a conservée à l'issue du bombardement.

### Exemple particulier de réalisation

Le substrat 10 de la première structure 1 est en silicium. Le substrat 20 de la seconde structure 2 est en silicium.

La couche 11 est un film d'oxyde de silicium d'une épaisseur de 150 nm. La couche 21 est un film d'oxyde de silicium d'une épaisseur de 150 nm. Le film d'oxyde de silicium peut être réalisé par un traitement thermique du substrat 10, par exemple dans un four, à 950°C, dans une atmosphère oxydante contenant de la vapeur d'eau.

Une couche de silicium 3 d'une épaisseur de 24 nm ± 2 nm est déposée sur la couche 11 par RPCVD (« *Remote Plasma-enhanced Chemical Vapor Deposition »),* par exemple à 550°C. Une couche de silicium additionnelle 4 d'une épaisseur de 24 nm ± 2 nm est déposée sur la couche 21 par RPCVD, par exemple à 550°C. Les surfaces des couches de silicium 3, 4 présentent une rugosité de l'ordre de 0,3 nm RMS.

Les couches de silicium 3, 4 sont soumises à un traitement de préparation de leur surface. La dernière étape avant l'étape b) est le retrait de l'oxyde de surface des couches de silicium 3, 4, par exemple par une immersion dans un bain d'acide fluorhydrique (« *HF last »).*

Les première et seconde structures 1, 2 sont ensuite disposées à l'intérieur d'une enceinte sous vide avec une pression résiduelle inférieure à 10⁻⁶ mbar. Les couches de silicium 3, 4 sont bombardées par un faisceau F d'ions argon. Le faisceau F présente une énergie de 800 eV et un courant de 77 mA. La pression pendant le bombardement est de 5,7 10⁻⁴ mbar. Le temps de bombardement est de 2 min. La vitesse d'abrasion est de 9,8 nm/min. Les parties 3a, 4a des couches de silicium 3, 4 conservées après bombardement présentent une épaisseur de 4 nm ± 1 nm. Du fait de l'énergie égale à 800 eV et d'une épaisseur faible des parties 3a, 4a des couches de silicium 3, 4, on obtient un mixage à l'interface de dépôt des couches de silicium 3, 4 sur les couches 11, 21 entre les ions argon et l'oxyde des couches 11, 21.

A titre d'exemple, en conservant les autres paramètres, une énergie du faisceau F de 1 keV conduit à une vitesse d'abrasion de 12 nm/min. A titre d'exemple additionnel, une tension d'accélération de 200 V et un courant de 150 mA conduisent à une vitesse d'abrasion des couches de silicium 3, 4 (polycristallines ou amorphes) de l'ordre de 4 nm/min.

Le collage par adhésion directe de l'étape c) entre les première et seconde structures 1, 2 intervient quasiment instantanément après la mise en contact des parties 3a, 4a des couches de silicium 3, 4 sous vide résiduel, et sans rupture de vide. L'étape c) est exécutée en exerçant une pression de 10 bar sur une surface libre de l'empilement 1, 2 suivant la normale à la surface libre.

Selon une variante particulière, les épaisseurs initiales des couches de silicium 3, 4 sont de 15 nm. Il est alors possible de réduire le temps de bombardement à 1 min pour obtenir les parties 3a, 4a des couches de silicium 3, 4 avec une épaisseur de 4 nm ± 1 nm. Une telle réduction du temps de bombardement permet de réduire l'échauffement des première et seconde structures 1, 2.

Selon une autre variante, la première structure 1 comporte un film de silicium 3 (avec une épaisseur de l'ordre de 2 nm) sur une couche d'oxyde 11 à base de SiO₂. Après bombardement (durée de 60 secondes, tension d'accélération de 200 V et un courant de 150 mA) du film de silicium 3, le film de silicium 3 est collé sur une surface de silicium de la seconde structure 2. On obtient un collage de type Si/Si amorphe/SiO₂ pour lequel il a été mesuré une énergie de collage de 3 J.m⁻² ± 0,4 J.m⁻² alors que le même collage sans le silicium amorphe (et donc sans bombardement) conduit à une énergie de 0,6 J.m⁻².

## Revendications

1. Procédé de collage d'une première structure (1) et d'une seconde structure (2), comportant les étapes :
a) fournir la première structure (1) et la seconde structure (2), la première structure (1) comportant une surface (100) sur laquelle est formée une couche de silicium (3) ;
b) bombarder la couche de silicium (3) par un faisceau (F) d'espèces configuré pour atteindre la surface (100) de la première structure (1), et pour conserver une partie (3a) de la couche de silicium (3) avec une rugosité de surface inférieure à 1 nm RMS à l'issue du bombardement;
c) coller la première structure (1) et la seconde structure (2) par une adhésion directe entre la partie (3a) de la couche de silicium (3) conservée lors de l'étape b) et la seconde structure (2), les étapes b) et c) étant exécutées au sein d'une même enceinte soumise à un vide inférieur à 10⁻⁴ mbar.

2. Procédé selon la revendication 1, **caractérisé en ce que** l'étape b) est exécutée de sorte que la partie (3a) de la couche de silicium (3) conservée présente une épaisseur comprise entre 0,2 nm et 10 nm, préférentiellement comprise entre 1 nm et 5 nm, plus préférentiellement comprise entre 2 nm et 5 nm.

3. Procédé selon la revendication 1 ou 2, **caractérisé en ce que** les espèces du faisceau (F) comportent au moins un élément sélectionné dans le groupe comportant Ar, Ne, N, H, O, He.

4. Procédé selon l'une des revendications 1 à 3, **caractérisé en ce que** la première structure (1) fournie lors de l'étape a) comporte successivement :
- un substrat (10) d'un premier matériau ;
- une couche (11) d'un deuxième matériau comportant la surface (100) sur laquelle est formée la couche de silicium (3).

5. Procédé selon l'une des revendications 1 à 4, **caractérisé en ce que** la seconde structure (2) fournie lors de l'étape a) comporte successivement :
- un substrat (20) d'un premier matériau ;
- une couche (21) d'un deuxième matériau sur laquelle s'opère l'adhésion directe lors de l'étape c).

6. Procédé selon la revendication 4 ou 5, **caractérisé en ce que** le deuxième matériau de la couche (11, 21) est sélectionné dans le groupe comportant un oxyde de silicium, un nitrure de silicium, un nitrure d'aluminium, un oxyde d'aluminium, un oxynitrure de silicium, un carbure de silicium, un diamant, un matériau de type III-V, un matériau de type II-VI, un matériau de type IV.

7. Procédé selon l'une des revendications 4 à 6, **caractérisé en ce que** le premier matériau du substrat (10, 20) est sélectionné dans le groupe comportant le silicium, un verre, un saphir, un matériau de type III-V, un diamant, un carbure de silicium, une alumine, un polymère, une céramique.

8. Procédé selon l'une des revendications 1 à 7, **caractérisé en ce que** les première et seconde structures (1, 2) forment un empilement lors de l'étape c), et **en ce que** l'étape c) est exécutée en exerçant une pression sur au moins une surface libre de l'empilement suivant la normale à la surface libre, la pression étant préférentiellement comprise entre 5 et 30 bar.

9. Procédé selon l'une des revendications 1 à 8, **caractérisé en ce qu'**il comporte une étape consistant à appliquer un recuit thermique à la première structure (1) avant l'étape b), le recuit thermique présentant une température T vérifiant T<T₂ où T₂ est la température au-delà de laquelle la première structure (1) est susceptible de se dégrader.

10. Procédé selon l'une des revendications 1 à 9, **caractérisé en ce que** la couche de silicium (3) est amorphe ou polycristalline.

11. Procédé selon l'une des revendications 1 à 10, **caractérisé en ce que** la première structure (1) fournie lors de l'étape a) comporte un oxyde de silicium formé sur la couche de silicium (3), et **en ce que** le procédé comporte une étape consistant à retirer l'oxyde de silicium avant l'étape b).

12. Procédé selon l'une des revendications 1 à 11, **caractérisé en ce que** l'étape a) comporte une étape consistant à déposer la couche de silicium (3) sur la surface (100) de la première structure (1), de préférence à une température inférieure à 600°C, plus préférentiellement inférieure à 500°C.

13. Procédé selon l'une des revendications 1 à 12, **caractérisé en ce que** la seconde structure (2) fournie lors de l'étape a) comporte une surface (200) sur laquelle est formée une couche de silicium additionnelle (4) ; **en ce que** le procédé comporte une étape b1) consistant à bombarder la couche de silicium additionnelle (4) par un faisceau (F) d'espèces configuré pour atteindre la surface (200) de la seconde structure (2), et pour conserver une partie (4a) de la couche de silicium additionnelle (4) avec une rugosité de surface inférieure à 1 nm RMS à l'issue du bombardement, l'étape b1) étant exécutée au sein de la même enceinte soumise au vide inférieur à 10⁻⁴ mbar ; et **en ce que** l'étape c) est exécutée de sorte que l'adhésion directe s'opère entre la partie (3a) de la couche de silicium (3) conservée lors de l'étape b) et la partie (4a) de la couche de silicium additionnelle (4) conservée lors de l'étape b1).

14. Procédé selon l'une des revendications 1 à 12, **caractérisé en ce que** la seconde structure (2) fournie lors de l'étape a) comporte une surface (200) sur laquelle s'opère l'adhésion directe lors de l'étape c) ; et **en ce que** le procédé comporte une étape consistant à bombarder la surface (200) avant l'étape c) par un faisceau (F) d'espèces configuré pour conserver une rugosité de surface inférieure à 1 nm RMS.

15. Procédé selon l'une des revendications 1 à 14, **caractérisé en ce qu'**il est dépourvu d'une étape de recuit thermique présentant une température supérieure à 100°C après l'étape c).

## Patentansprüche

1. Verfahren zum Verbinden einer ersten Struktur (1) und einer zweiten Struktur (2), wobei das Verfahren die folgenden Schritte aufweist:
a) Bereitstellen der ersten Struktur (1) und der zweiten Struktur (2), wobei die erste Struktur (1) eine Oberfläche (100) aufweist, auf der eine Siliziumschicht (3) ausgebildet ist;
b) Beschießen der Siliziumschicht (3) mit einem Strahl (F) derart, dass er die Oberfläche (100) der ersten Struktur (1) erreicht, und dass ein Teil (3a) der Siliziumschicht (3) mit einer Oberflächenrauigkeit von weniger als 1 nm RMS nach Abschluss des Beschusses erhalten bleibt;
c) Verbinden der ersten Struktur (1) und der zweiten Struktur (2) durch direktes Verbinden zwischen dem in Schritt b) erhaltenen Teil (3a) der Siliziumschicht (3) und der zweiten Struktur (2), wobei die Schritte b) und c) in der gleichen Kammer ausgeführt werden, die einem Unterdruck von weniger als 10⁻⁴ mbar ausgesetzt ist.

2. Verfahren nach Anspruch 1, **dadurch gekennzeichnet, dass** Schritt b) so ausgeführt wird, dass der erhalten gebliebene Teil (3a) der Siliziumschicht (3) eine Dicke zwischen 0,2 nm und 10 nm, vorzugsweise zwischen 1 nm und 5 nm, noch bevorzugter zwischen 2 nm und 5 nm aufweist.

3. Verfahren nach Anspruch 1 oder 2, **dadurch gekennzeichnet, dass** die Spezies des Strahls (F) mindestens ein Element aufweist, das aus der Gruppe ausgewählt ist, die Ar, Ne, N, H, O, und He umfasst.

4. Verfahren nach einem der Ansprüche 1 bis 3, **dadurch gekennzeichnet, dass** die in Schritt a) bereitgestellte erste Struktur (1) nacheinander Folgendes aufweist:
- ein Substrat (10), das aus einem ersten Material hergestellt ist
- eine aus einem zweiten Material hergestellte Schicht (11), die die Oberfläche (100) aufweist, auf der die Siliziumschicht (3) gebildet wird.

5. Verfahren nach einem der Ansprüche 1 bis 4, **dadurch gekennzeichnet, dass** die in Schritt a) bereitgestellte zweite Struktur (2) nacheinander Folgendes aufweist:
- ein Substrat (20), das aus einem ersten Material hergestellt ist;
- eine Schicht (21) aus einem zweiten Material, auf der in Schritt c) das direkte Verbinden erfolgt.

6. Verfahren nach Anspruch 4 oder 5, **dadurch gekennzeichnet, dass** das zweite Material der Schicht (11, 21) ausgewählt ist aus der Gruppe, die ein Siliziumoxid, ein Siliziumnitrid und Aluminiumnitrid, ein Aluminiumoxid, das Siliziumoxynitrid, ein Siliziumkarbid, einen Diamanten, ein Material vom III-V-Typ, ein Material vom II-VI-Typ und ein Material vom IV-Typ aufweist.

7. Verfahren nach einem der Ansprüche 4 bis 6, **dadurch gekennzeichnet, dass** das erste Material des Substrats (10, 20) ausgewählt ist aus der Gruppe bestehend aus Silizium, einem Glas, einem Saphir, einem Material vom III-V-Typ, einem Diamant, einem Siliziumkarbid, einem Aluminiumoxid, einem Polymer und einer Keramik.

8. Verfahren nach einem der Ansprüche 1 bis 7, **dadurch gekennzeichnet, dass** die ersten und zweiten Strukturen (1, 2) in Schritt c) einen Stapel bilden, und dass der Schritt c) durch Ausüben eines Drucks auf mindestens eine freie Oberfläche des Stapels in der senkrechten Richtung zur freien Oberfläche ausgeführt wird, wobei der Druck vorzugsweise zwischen 5 und 30 bar liegt.

9. Verfahren nach einem der Ansprüche 1 bis 8, **dadurch gekennzeichnet, dass** es einen Schritt aufweist, der darin besteht, die erste Struktur (1) vor dem Schritt b) einem thermischen Glühen zu unterziehen, wobei das thermische Glühen eine Temperatur T aufweist, die T<T₂ verifiziert, wobei T₂ die Temperatur ist, oberhalb derer die erste Struktur (1) verschlechtert bzw. degradiert werden kann.

10. Verfahren nach einem der Ansprüche 1 bis 9, **dadurch gekennzeichnet, dass** die Siliziumschicht (3) amorph oder polykristallin ist.

11. Verfahren nach einem der Ansprüche 1 bis 10, **dadurch gekennzeichnet, dass** die in Schritt a) bereitgestellte erste Struktur (1) ein auf der Siliziumschicht (3) gebildetes Siliziumoxid aufweist, und dass das Verfahren einen Schritt umfasst, der darin besteht, das Siliziumoxid vor Schritt b) zu entfernen.

12. Verfahren nach einem der Ansprüche 1 bis 11, **dadurch gekennzeichnet, dass** Schritt a) einen Schritt aufweist, der darin besteht, die Siliziumschicht (3) auf der Oberfläche (100) der ersten Struktur (1) abzuscheiden, vorzugsweise bei einer Temperatur von weniger als 600°C, mehr bevorzugt weniger als 500°C.

13. Verfahren nach einem der Ansprüche 1 bis 12, **dadurch gekennzeichnet, dass** die in Schritt a) bereitgestellte zweite Struktur (2) eine Oberfläche (200) aufweist, auf der eine zusätzliche Siliziumschicht (4) gebildet wird; dass das Verfahren einen Schritt b1) aufweist, der darin besteht, die zusätzliche Siliziumschicht (4) mit einem Strahl (F) von Spezies zu beschießen, der so konfiguriert ist, dass er die Oberfläche (200) der zweiten Struktur (2) erreicht, und einen Teil (4a) der zusätzlichen Siliziumschicht (4) mit einer Oberflächenrauheit von weniger als 1 nm RMS nach Abschluss des Beschusses zu erhalten, wobei der Schritt b1) in derselben Kammer ausgeführt wird, die einem Unterdruck von weniger als 10⁻⁴ mbar ausgesetzt ist; und dass Schritt c) so ausgeführt wird, dass eine direkte Verbindung zwischen dem Teil (3a) der in Schritt b) erhaltenen Siliziumschicht (3) und dem Teil (4a) der in Schritt b1) erhaltenen zusätzlichen Siliziumschicht (4) erhalten wird.

14. Verfahren nach einem der Ansprüche 1 bis 12, **dadurch gekennzeichnet, dass** die in Schritt a) vorgesehene zweite Struktur (2) eine Oberfläche (200) aufweist, auf der in Schritt c) das direkte Verbinden stattfindet; und dass das Verfahren einen Schritt umfasst, der darin besteht, die Oberfläche (200) vor Schritt c) mit einem Strahl (F) von Spezies zu beschießen, die so konfiguriert sind, dass sie eine Oberflächenrauigkeit von weniger als 1 nm RMS erhalten.

15. Verfahren nach einem der Ansprüche 1 bis 14, **dadurch gekennzeichnet, dass** es keinen thermischen Glühschritt aufweist, der nach dem Schritt c) eine Temperatur von mehr als 100°C umfasst.

## Claims

1. Method for bonding a first structure (1) and a second structure (2), comprising the following steps:
a) providing the first structure (1) and a second structure (2), the first structure (1) comprising a surface (100) on which a silicon layer (3) is formed;
b) bombarding the silicon layer (3) by a beam (F) of species configured to reach the surface (100) of the first structure (1), and to preserve a part (3a) of the silicon layer (3) with a surface roughness of less than 1 nm RMS on completion of the bombardment;
c) bonding the first structure (1) and second structure (2) by direct bonding between the part (3a) of the silicon layer (3) preserved in step b) and the second structure (2), steps b) and c) being executed in the same chamber subjected to a vacuum of less than 10⁻⁴ mbar.

2. Method according to claim 1, **characterized in that** step b) is executed so that the preserved part (3a) of the silicon layer (3) presents a thickness comprised between 0.2 nm and 10 nm, preferentially comprised between 1 nm and 5 nm, more preferentially comprised between 2 nm and 5 nm.

3. Method according to claim 1 or 2, **characterized in that** the species of the beam (F) comprise at least one element selected from the group comprising Ar, Ne, N, H, O, and He.

4. Method according to one of claims 1 to 3, **characterized in that** the first structure (1) provided in step a) successively comprises:
- a substrate (10) made from a first material;
- a layer (11) made from a second material comprising the surface (100) on which the silicon layer (3) is formed.

5. Method according to one of claims 1 to 4, **characterized in that** the second structure (2) provided in step a) successively comprises:
- a substrate (20) made from a first material;
- a layer (21) made from a second material on which the direct bonding takes place in step c).

6. Method according to claim 4 or 5, **characterized in that** the second material of the layer (11, 21) is selected from the group comprising a silicon oxide, a silicon nitride, and aluminium nitride, an aluminium oxide, the silicon oxynitride, a silicon carbide, a diamond, a material of III-V type, a material of II-VI type, and a material of IV type.

7. Method according to one of claims 4 to 6, **characterized in that** the first material of the substrate (10, 20) is selected from the group comprising silicon, a glass, a sapphire, a material of III-V type, a diamond, a silicon carbide, an alumina, a polymer, and a ceramic.

8. Method according to one of claims 1 to 7, **characterized in that** the first and second structures (1, 2) form a stack in step c), and **in that** the step c) is executed by exerting a pressure on at least one free surface of the stack in the perpendicular direction to the free surface, the pressure being preferentially comprised between 5 and 30 bar.

9. Method according to one of claims 1 to 8, **characterized in that** it comprises a step consisting in applying a thermal annealing to the first structure (1) before step b), the thermal annealing presenting a temperature T verifying T<T₂ where T₂ is the temperature above which the first structure (1) is liable to be degraded.

10. Method according to one of claims 1 to 9, **characterized in that** the silicon layer (3) is amorphous or polycrystalline.

11. Method according to one of claims 1 to 10, **characterized in that** the first structure (1) provided in step a) comprises a silicon oxide formed on the silicon layer (3), and **in that** the method comprises a step consisting in removing the silicon oxide before step b).

12. Method according to one of claims 1 to 11, **characterized in that** step a) comprises a step consisting in depositing the silicon layer (3) on the surface (100) of the first structure (1), preferably at a temperature of less than 600°C, more preferentially less than 500°C.

13. Method according to one of claims 1 to 12, **characterized in that the** second structure (2) provided in step a) comprises a surface (200) on which an additional silicon layer (4) is formed; **in that** the method comprises a step b1) consisting in bombarding the additional silicon layer (4) by a beam (F) of species configured to reach the surface (200) of the second structure (2), and to preserve a part (4a) of the additional silicon layer (4) with a surface roughness of less than 1 nm RMS on completion of the bombardment, step b1) being executed in the same chamber subjected to a vacuum of less than 10⁻⁴ mbar; and **in that** step c) is executed in such a way that direct bonding takes place between the part (3a) of the silicon layer (3) preserved in step b) and the part (4a) of the additional silicon layer (4) preserved in step b1).

14. Method according to one of claims 1 to 12, **characterized in that** the second structure (2) provided in step a) comprises a surface (200) on which the direct bonding takes place in step c); and **in that** the method comprises a step consisting in bombarding the surface (200) before step c) by a beam (F) of species configured to preserve a surface roughness of less than 1 nm RMS.

15. Method according to one of claims 1 to 14, **characterized in that** it does not comprise a thermal annealing step presenting a temperature of more than 100°C after step c).
